# EUROPEAN PATENT APPLICATION

(11) **EP 3 664 233 A1**
(43) Date of publication of application: **10.06.2020**
(21) Application number: 18210222.8
(22) Date of filing: 04.12.2018
(51) Int. Cl.: H01S 5/0625, H01S 5/06, H01S 5/50, H01S 5/10, H01S 5/026, H01S 5/028

(54) **OPTICAL AMPLIFIER WITH INCREASED DYNAMIC RANGE**

(71) Applicant: Huawei Technologies Co., Ltd., Shenzhen, Guangdong 518129 (CN)
(72) Inventor: LEALMAN, Ian, 80992 Munich (DE); BORGHESANI, Anna, 80992 Munich (DE); YU, Liqiang, 80992 Munich (DE)
(74) Representative: Pfenning, Meinig & Partner mbB

(57) **Abstract**

An optical amplifier having a front face, a rear face and an optical cavity, the cavity having a length defined between the front face and the rear face, the cavity comprising: a first section adjacent to the front face having a bias that is controllable between loss, zero bias and gain; and a second section adjacent to the rear face, wherein the second section has a bias that is controllable between zero bias and gain; wherein the length of the first section is shorter than the length of the second section.

## Description

### BACKGROUND

This invention relates to optical amplifier devices, for example to improving the input power range of such devices.

High-performance and low-cost semiconductor optical amplifier (SOA) and variable optical attenuator (VOA) modules are used in applications such as large-capacity and high-speed optical access networks.

A conventional optical amplifier or attenuator generally comprises a semiconductor block which has a front face or facet, a rear face or facet opposite to the front facet and an optical cavity formed therebetween. The cavity traditionally comprises an active layer interposed between layers of p- or n-type semiconductor material and defines a waveguide structure, which may be a ridge waveguide (RW) or a buried heterostructure (BH) waveguide. One or more coating layer(s), such as anti-reflection (AR) coatings, may be applied to the front and the rear facets.

Such devices may be driven by a current source, a voltage source or a switchable source so that there is either gain (to amplify) or loss (to attenuate) of the light travelling along the cavity, by stimulation or absorption from or by the active region of the device.

Compact modules are needed that can operate over distances of 0 to 40km without forward error correction (FEC), or 80km with FEC. In the current generation of modules this is achieved by using separately packaged SOA and VOA components. However, the use of two chips and separate packages is both too large and too expensive for the planned next generation modules.

One approach is to replace the phase detector in the receive module with an avalanche photodiode (APD). However, this approach can only cover a transmission distance of 30km without FEC (ER4 lite), which falls short of the 40km distance required in the ER4 standard.

There are several other methods proposed, including using a laser integrated with the SOA to provide a holding beam for automatic gain control. A method has also been proposed using a device with multiple equal-length sections that can be independently forward biased to provide gain, or zero or reverse biased to provide attenuation, as disclosed in US 2006/0215255 A1. It is desirable to produce an improved SOA device that can operate over a wide range of input powers.

### SUMMARY OF THE INVENTION

According to one aspect there is provided an optical amplifier having a front face, a rear face and an optical cavity, the cavity having a length defined between the front face and the rear face, the cavity comprising: a first section adjacent to the front face having a bias that is controllable between loss, zero bias and gain; and a second section adjacent to the rear face, wherein the second section has a bias that is controllable between zero bias and gain; wherein the length of the first section is shorter than the length of the second section.

This allows the device to operate over a wider dynamic range of input powers and ensures that the output power from the second longer gain section maintains a power level between the minimum and maximum powers that the receive power detectors can accept, while also ensuring that the signal power at the SOA output does not become saturated such that the SOA causes patterning on the signal data.

The sections may be continuous regions biasable in a particular way. The sections may extend along the length of the cavity The length of the first section may be less than 80% or less than 60% or less than 50% of the length of the second section.

The cavity may comprise a substrate and a waveguide optically coupled to the substrate. The waveguide may be a ridge waveguide. The waveguide may be a buried heterostructure waveguide. The described technique is therefore compatible with a variety of device structures.

The waveguide may be symmetric about an axis parallel to the length of the cavity. This is a convenient waveguide configuration that is straightforward to manufacture.

The substrate may be a semiconductor substrate. The substrate may comprise a first semiconductor layer of a first doping type, a second semiconductor layer of a second doping type opposite to the first type, and an active region located between the first and second semiconductor layers, the first and second semiconductor layers being elongate in a direction extending between the rear face and the front face of the amplifier. This is a structure that is compatible with common semiconductor product manufacturing methods.

The first and second sections of the cavity may be independently biasable. This may allow the device to operate over a wider dynamic range of input powers.

The optical amplifier may further comprise a third section between the first section and the second section, wherein the length of the third section is shorter than the length of the second section and the bias of the third section is controllable between gain and loss. This may further increase the dynamic power range of the device.

The first, second and third sections of the cavity may be independently biasable. This may allow the device to operate over a wider dynamic range of input powers.

The length of one of the first section or the third section may be shorter than the length of the other of the first section or the third section. These are alternative configurations.

The cavity may be inclined with respect to a direction perpendicular to the rear face. This may help to improve the power efficiency of the device.

The front face and/or the rear face may be cleaved facets. Cleaving is a convenient manufacturing method for producing the front and rear faces of the cavity.

The front face and/or the rear face may be coated with an anti-reflection coating. The coating may prevent reflection of light from the facets back into the cavity to optimize amplification.

At start-up of the optical amplifier, all of the sections of the cavity may be zero biased. The photocurrent can then be measured in the first section. This will allow the input power to the device to be determined and allow the optimum operating range to be selected.

### BRIEF DESCRIPTION OF THE FIGURES

The present invention will now be described by way of example with reference to the accompanying drawings.

In the drawings:
Figure 1 shows a side view of an example of a semiconductor device.
Figures 2 shows a cross-section along A-A of Figure 1.
Figure 3 shows a side view of another example of a semiconductor device.
Figures 4 to 7 show the results of calculations to provide an indication of the relative section lengths required for typical two- and three-section chips for system link lengths of 40 and 80km. Figure 4 and 5 show the results for a two-section device at 40 and 80km respectively. Figure 6 and 7 show the results for a three-section device at 40 and 80km respectively.
Figure 8 shows a plan view (taken from mask images) of prototype chip used.

### DETAILED DESCRIPTION OF THE INVENTION

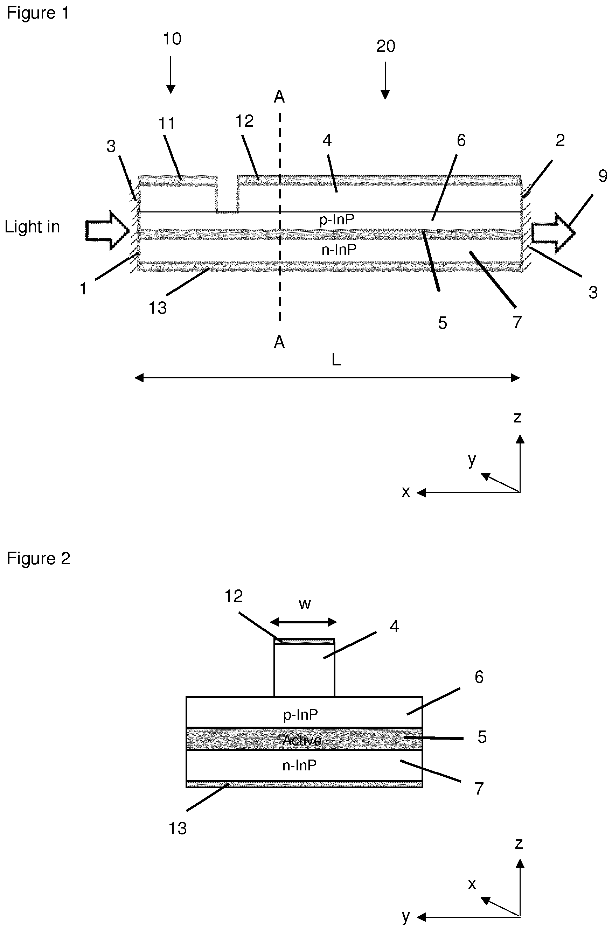

Figure 1 shows a side view of one example of a semiconductor device according to the present invention. The device comprises a semiconductor block which has a front face or facet 1, a rear face or facet 2 opposite to the front face or facet and an optical cavity formed therebetween. The total length of the cavity is L. The cavity may be straight, as shown here, or the cavity may be inclined or at an angle relative to a direction perpendicular to the front facet.

In an implementation the front and rear facets may be aligned parallel to one another. The rear facet may be orthogonal to the length of the cavity. The front facet may also be orthogonal to the length of the cavity. An anti-reflection (AR) coating 3 can be applied to one or optionally both of the front and rear facets.

The cavity comprises an active layer 5 which may be may be interposed between layers of p- and n-type semiconductor material, shown at 6 and 7 respectively. The cavity may also comprise additional semiconductor outrigger layers beneath layers 5, 6, 7 and 8. In this example, the semiconductor layers are made from InP. However, other semiconductor materials, such as GaAs, may be used. The material forming the cavity may be selectively doped in the region of the p- and n-type layers 6, 7. The optical cavity also comprises an etched waveguide layer 4, which provides lateral waveguiding.

The device has a common n electrode 13 on one side of the cavity, which may be adjacent to the floor of the cavity. On the opposite side of the cavity are separate electrodes 11, 12 attached to each of the first and second sections 10, 20, such that each section is independently biasable. The main gain section 20 is forward biased and driven by a current source. The short section 10 may be driven by a voltage source, but could be driven by a source that is switchable between current and voltage. The supply of a forward bias current or voltage to the electrodes of section 10, such that the section acts as a gain section, causes light emission to be stimulated from that section of the cavity. When at zero or reverse bias, the section 10 is driven by a voltage source. The application of a reverse bias voltage to the electrodes, such that the section 10 acts as an absorber section, causes light to be absorbed in that section of the cavity. The sections are therefore independently biasable and the electrodes 11, 12 are electrically isolated from one another by an etch section or a section of electrically insulating material.

Light is emitted from the end of the waveguide at the rear face of the SOA device, shown at 9.

Figure 2 shows a vertical section along A-A of Figure 1. At each point along the length of the cavity, the waveguide layer 4 has a width w defined transverse to the length of the cavity. The width of the waveguide may be constant or it may vary along the length of the cavity. In the vertical section, the active layer 5, the confinement modification layer 8 and the semiconductor layers 6 and 7 all form part of the waveguide and guide the light in the vertical direction. The waveguide is thus formed by any layer or combination of layers that have a higher refractive index than the surrounding substrate and cladding layers, allowing the layer(s) to provide optical guiding.

The waveguide also has an optical confinement factor, Γ (Gamma). The optical confinement factor of a waveguide is defined as the proportion of the light in the guided mode which is contained within the active region or waveguide core. i.e. the section of the structure that generates the optical gain in the SOA device.

The waveguide may be a ridge waveguide. The ridge waveguide may be created by etching parallel trenches in the material either side of the waveguide layer 4 to create an isolated projecting strip, typically less than 5 µm wide and several hundred µm long. A material with a lower refractive index than the waveguide material can be deposited at the sides of the ridge to guide injected current into the ridge. Alternatively, the ridge may be surrounded by air on the three sides that are not in contact with the substrate beneath the waveguide. The ridge provides the lateral waveguiding, since the other layers in the structure above the active layer have a higher index than the air or passivation layers (typically silica or silicon nitride) in the etched channel regions.

Referring to Figure 1, the device has a first section of relatively short length 10 adjacent to the input front facet 1 of the device. This first section can be either forward biased to provide gain for low input signals, or reverse biased for larger input signals. The second section 20 is a gain region which has a longer relative length than the first short section. The second section may have a length that is, for example, 2 times, 5 times, or 10 times longer than the length of the first section.

The independently biasable short section 10 at the input to the device can be digitally switched between gain and loss. A forward, reverse, or zero bias can be applied to the short section 10, by a voltage source or switchable source, as described above. A forward bias current is applied to the second section 20. This ensures that the output power of the final gain section 20 remains within a limited output power range for a wide range of input powers.

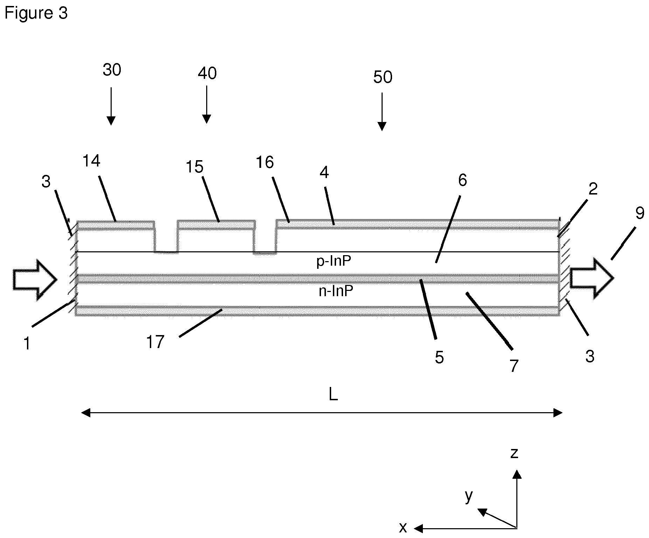

Figure 3 shows another example of a SOA in accordance with the present invention. This device has three sections 30, 40, 50 along the length of the cavity. The device has two relatively short sections 30, 40 and a longer gain section 50. Each section has a corresponding p electrode 14, 15, 16. The cavity has a common n electrode 17 on the opposite side of the cavity to the p electrodes 14, 15, 16. Each section 30, 40, 50 of the cavity is therefore independently biasable, as described above.

The section 30 may be longer than the section 40 or vice versa. Alternatively, sections 30 and 40 may be of equal length. Sections 30, 40 are both shorter than the gain section 50.

At start-up of the device, the individual sections may be all zero biased. The photocurrent can then be measured in the first short section 30. This will allow the input power to the device to be determined and allow the optimum operating range to be selected.

In an embodiment of the two- and three-section devices, the short SOA gain control sections 10 and 30, 40 (also called short section) are either turned fully off ('OFF') with zero bias or a reverse biased voltage applied, typically between 0 to -3V to act as absorbers or fully on ('ON') with a forward bias voltage or current to act as amplifiers. In an embodiment, the short sections may alternatively be used under reduced forward bias. The amount of reduction of the forward bias may depend on the length of the short sections. Any reduction of the forward bias from 100% is possible. In some examples, the forward bias may be reduced down in the range of 10% to 30% of the typical operating current. The simple digital ON/OFF approach also greatly simplifies the required control electronics.

When a voltage is applied to the short sections in the 'ON' state the voltage is chosen to match the long gain section voltage at its typical operating current so that the sections are biased to a similar current density. A fixed reverse bias voltage may be used for the 'OFF' configuration. Having some reverse bias is advantageous as this stops the absorber from being saturated by the absorber light.

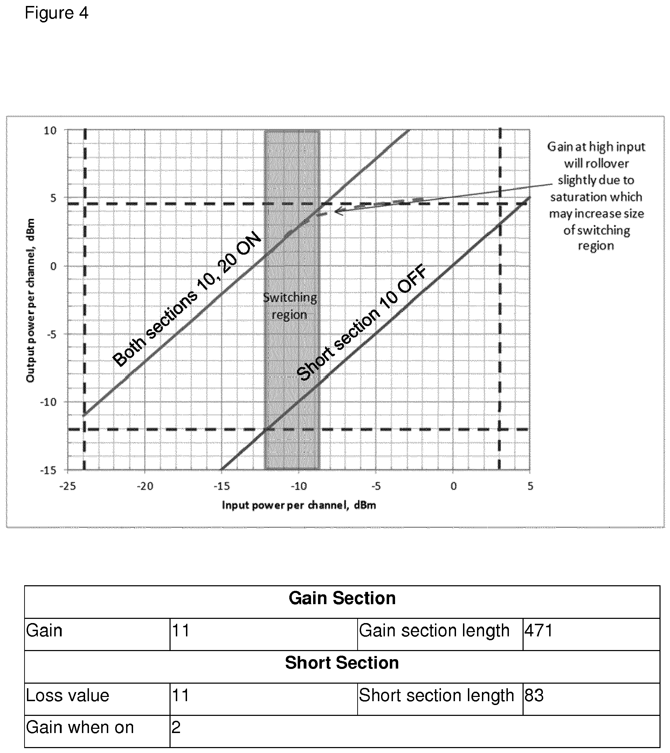

Figures 4 to 7 show the results of calculations to provide an indication of the relative section lengths required for typical two- and three-section chips for system link lengths of 40 and 80km. In the tables accompanying these figures, the gain and loss value are target values and the gain and short section lengths indicate the respective lengths calculated to obtain these target values. Specifically, the magnitude of the loss in the short section (loss value) was obtained from an initial measurement of an SOA with the same waveguide. A loss of 40dB was obtained for a 300 um long SOA at 0 or reverse bias. The short section length for the configurations in figures 4 to 7 was obtained by scaling the so obtained loss value. The gain value per unit length for the gain section has been obtained by measuring the optical gain of SOAs of various lengths, for instance 300 um to 1000 um. The phase detector dynamic range is -12dBm to +4.5dBm. In the calculations, the output power of the SOA per channel was limited to 3dBm to reduce crosstalk. The minimum input power into the amplifier (for the largest fibre loss) was: -18dBm (-24dBm per channel) for 40km and -26dBm (-32dBm per channel) for 80km (which also assumes that FEC is used). The gain and loss values in Figures 4 to 7 were extracted from initial measured data for a seven-well SOA.

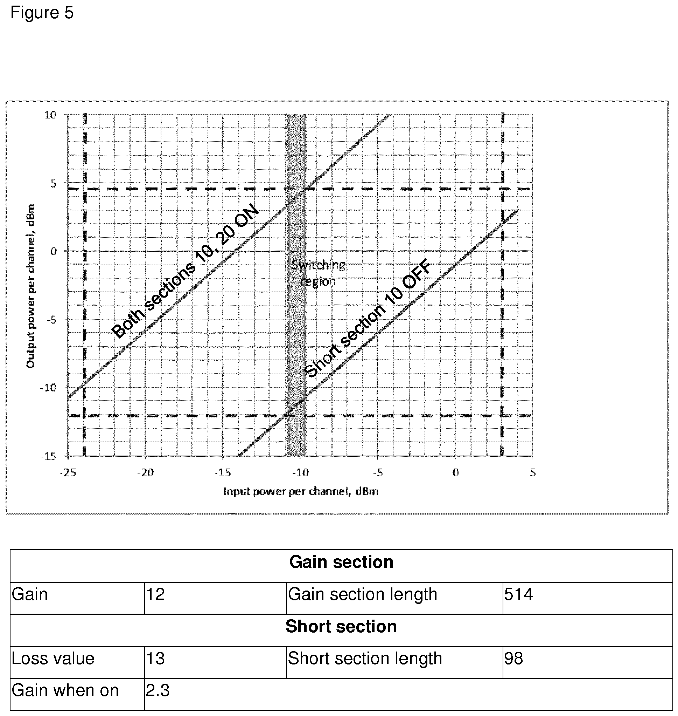

Figure 4 and 5 show the results for a two-section device, as in Figure 1, at 40 and 80km respectively. The output power per channel is plotted as a function of the input power per channel when the two sections are both ON and when the first section is OFF and acting as an absorber and the long gain section is ON. In Figure 4, the gain at high input will rollover slightly due to saturation, which may require an increase in the size of the 'switching region' shown in Figures 4 and 5.

It is advantageous for the switching region to be large to ensure that all of the four channels are within the same configuration when differences in the powers of the four transmitter channels (as per the system specification) are accounted for, as well as the polarisation dependence of the SOA and the gain tit across the four wavelengths. As an example, in some implementations, the chip may have 3dB gain tilt and polarisation and the channels may differ in power by up to 3dB from the specification at end of life. In this case, it may be advantageous to have at least 6dB of overlap. The gain and absorption of the SOA also have a wavelength dependence, i.e. a gain and loss tilt that must also be accommodated for. The long gain section bias can also be adjusted to alter the overlap region.

In Figure 5, the small overlap region indicates that this embodiment would probably not work over the whole dynamic range as the four channels may not be in the same configuration when any power differences are accounted for.

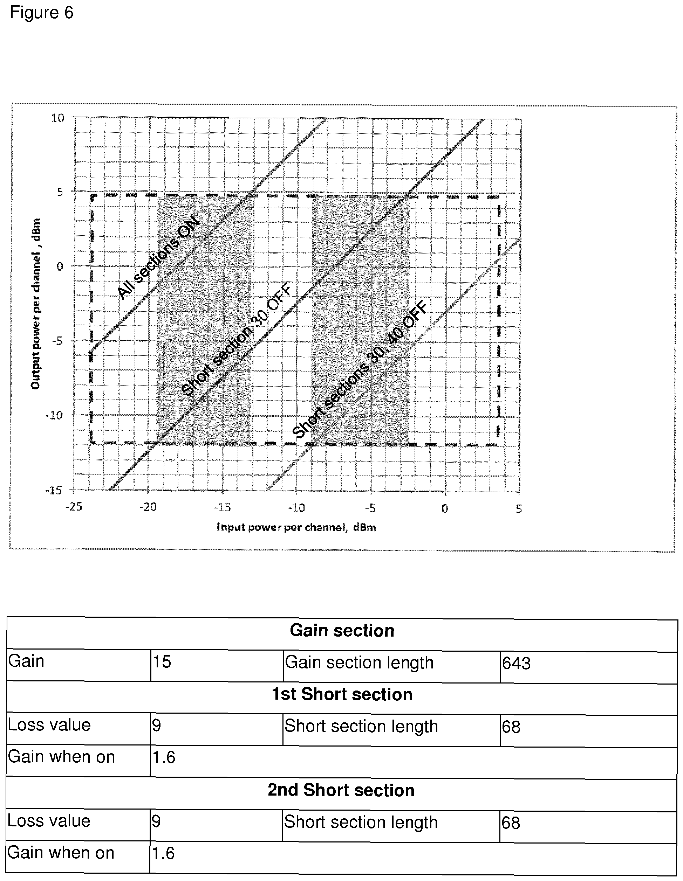

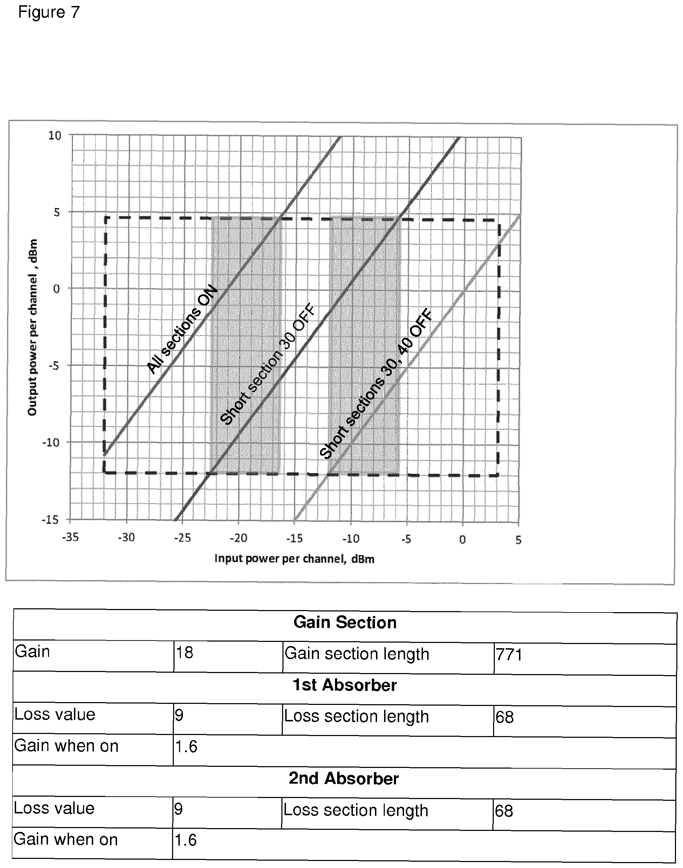

Figure 6 and 7 show the results for a three-section device, as in Figure 3, at 40 and 80km respectively. For 40km (see Figure 6), if the total input power is in the range of -18dBm (average of -24dBm per channel) to -6dBm (average of -12dBm per channel) then all three sections 30, 40, 50 should be forward biased ('ON') to provide the maximum small signal gain of ∼18dB. If the input power range is in the range -6dBm to +4dBm then the first short section 30, adjacent to the input facet, should be zero or reverse biased ('OFF') to provide ∼9dB of attenuation, while the second short section 40 and the main gain section 50 are forward biased ('ON') to provide a small signal gain of around 7.5dB. If the input power is in the range +4dBm to +9dBm then both of the front sections 30, 40 should be zero or reverse biased ('OFF') and only the long rear section 50 forward biased to provide a net loss of around 3dB.

In the case of the three-section device for 80km (see Figure 7) if the total input power is in the range -26dBm (average of -32dBm per channel) to -14dBm (average of -20dBm per channel) then all three sections 30, 40, 50 should be forward biased ('ON') to provide the maximum small signal gain of ∼21dB. If the input power range is in the range -14dBm to -4dBm then the first short section 30, adjacent to the input facet, should be zero or reverse biased ('OFF', 0 mA) to provide ∼9dB of attenuation, while the second short section 40 and the main gain section 50 are forward biased ('ON') to provide a small signal gain of around 11dB. Finally if the input power is in the range of -4dBm to +9dBm then both of the front sections 30, 40 should be zero or reverse biased ('OFF') and only the long rear section 50 forward biased ('ON') to provide a 0dB net gain.

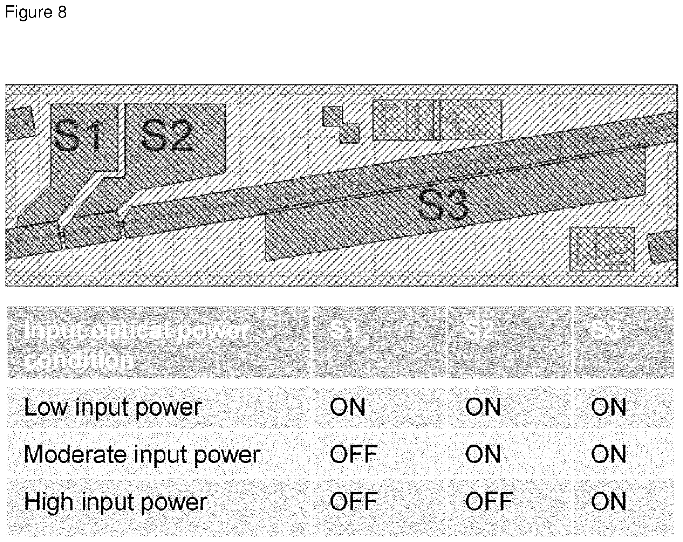

In the design were the short SOA gain control sections are either turned fully off ('OFF') or fully on ('ON'), which uses a nine-well active layer, absorber sections of 40µm or less cover the dynamic range and four wavelengths of the 40km application. Figure 8 shows a schematic of the chip used where the total chip length is 0.8mm and each of the absorber section S1 and S2 are 0.04mm long.

The longer gain section is shown as S3. In this example, the waveguide is inclined with respect to a direction perpendicular to the front and rear facets. This may help to reduce reflection of light at the output facet. This device is capable of operating at both the minimum input power, with an input sensitivity of -24dBm, and at beyond the maximum input power without introducing errors.

The absorption in the short sections varies with wavelength and optionally a reverse bias may be applied to the absorber sections to reduce the gain variation between the channels.

In the approach used in the present invention, the device will operate over set input power ranges (with overlap regions to minimize the chance of range switching and error bursts) in a digital fashion, where the absorbers either simply forward biased to provide gain or reverse biased to provide loss.

This allows the device to operate over a wider dynamic range of input powers to provide a design that offers more overlap between the operating regions to relax the fabrication constraints in terms of chip gain, PDG and also power fluctuations between the multiple laser channels that pass through the device.

This ensures that the output power from the last and longer gain section maintains a power level between the minimum and maximum powers that the receive phase detectors can accept and also ensuring that the signal power at the SOA output does not become saturated such that the SOA causes patterning on the signal data, which would degrade the quality of the eye diagram and bit error rate (BER) in the receiver.

Although the examples above describe a device which has a ridge waveguide, the present invention can also be applied to devices having a buried heterostructure waveguide.

The waveguide may be inclined relative to a direction perpendicular to the front face of the cavity such that the waveguide slopes upwards towards the rear face. The waveguide may be inclined relative to the cavity length by an angle of 5□, 10□, 15□ or 20□.

This device could be integrated with other devices which benefit from variable amplification to allow for operation over a wider range of dynamic input powers. For example, the device could be integrated with an optical filter or demultiplexer followed by a power detector or array of power detectors.

The device can be used with wavelength-division multiplexing, where the gain tilt and polarisation should be controlled for all operating conditions.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention.

## Claims

1. An optical amplifier having a front face, a rear face and an optical cavity, the cavity having a length defined between the front face and the rear face, the cavity comprising:
a first section adjacent to the front face having a bias that is controllable between loss, zero bias and gain; and
a second section adjacent to the rear face, wherein the second section has a bias that is controllable between zero bias and gain;
wherein the length of the first section is shorter than the length of the second section.

2. The optical amplifier of claim 1, wherein the cavity comprises a substrate and a waveguide optically coupled to the substrate.

3. The optical amplifier of claim 2, wherein the waveguide is a ridge waveguide.

4. The optical amplifier of claim 2, wherein the waveguide is a buried heterostructure waveguide.

5. The optical amplifier of any of claims 2 to 4, wherein the waveguide is symmetric about an axis parallel to the length of the cavity.

6. The optical amplifier of any of claims 2 to 5, wherein the substrate is a semiconductor substrate.

7. The optical amplifier of claim 6, wherein the substrate comprises a first semiconductor layer of a first doping type, a second semiconductor layer of a second doping type opposite to the first type, and an active region located between the first and second semiconductor layers, the first and second semiconductor layers being elongate in a direction extending between the rear face and the front face of the amplifier.

8. The optical amplifier of any preceding claim, wherein the first and second sections of the cavity are independently biasable.

9. The optical amplifier of any preceding claim, further comprising a third section between the first section and the second section, wherein the length of the third section is shorter than the length of the second section and the bias of the third section is controllable between gain and loss.

10. The optical amplifier of claim 9, wherein the first, second and third sections of the cavity are independently biasable.

11. The optical amplifier of claim 9 or claim 10, wherein the length of one of the first section or the third section is shorter than the length of the other of the first section or the third section.

12. The optical amplifier of any preceding claim, wherein the cavity is inclined with respect to a direction perpendicular to the rear face.

13. The optical amplifier of any preceding claim, wherein the front face and/or the rear face are cleaved facets.

14. The optical amplifier of any preceding claim, wherein the front face and/or the rear face is coated with an anti-reflection coating.

15. The optical amplifier of any preceding claim, wherein, at start-up of the optical amplifier, all of the sections of the cavity are zero biased.
